# EUROPEAN PATENT SPECIFICATION

(11) **EP 1 396 017 B1**
(45) Date of publication and mention of the grant of the patent: **13.06.2012**
(21) Application number: 01995960.0
(22) Date of filing: 28.11.2001
(51) Int. Cl.: H01L 21/3213, H01L 21/02

(54) **AN ISOTROPIC ETCH TO FORM MIM CAPACITOR TOP PLATES**
ISOTROPES ÄTZVERFAHREN FÜR DIE HERSTELLUNG VON OBEREN ELEKTRODEN EINES MIM-KONDENSATORS
ATTAQUE ANISOTROPE POUR FORMER DES PLAQUES SUPERIEURES DE CONDENSATEUR MIM

(30) Priority: 21.12.2000 US 742644
(43) Date of publication of application: 10.03.2004
(73) Proprietor: Infineon Technologies AG, 85579 Neubiberg (DE)
(72) Inventor: NING, X., J., Mohegan Lake, NY 10547 (US)
(74) Representative: Viering, Jentschura & Partner
(86) International application number: PCT/US2001/044551
(87) International publication number: WO 2002/052631

(56) References cited:
- EP-A- 0 661 730
- EP-A- 0 932 192
- US-A- 5 258 093
- US-A- 5 443 688
- US-A- 5 830 792
- MASAKAZU FURUKAWA: "PROCESS DEPENDENCE ON TWO-CAPACITOR MATCHING PROPERTIES WITH DIFFERENT ETCHING TECHNIQUE" IEEE TRANSACTIONS ON ELECTRON DEVICES, IEEE INC. NEW YORK, US, vol. 39, no. 2, 1 February 1992 (1992-02-01), pages 453-454, XP000247216 ISSN: 0018-9383

## Description

### TECHNICAL FIELD

This invention generally relates to the fabrication of integrated circuits, and more particularly to fabrication of metal-insulator-metal (MIM) capacitors.

### BACKGROUND OF THE INVENTION

Capacitors are used extensively in electronic devices for storing an electric charge. Capacitors essentially comprise two conductive plates separated by an insulator. Capacitors are used in filters, analog-to- digital converters, memory devices, various control applications, and mixed signal and analog devices, for example.

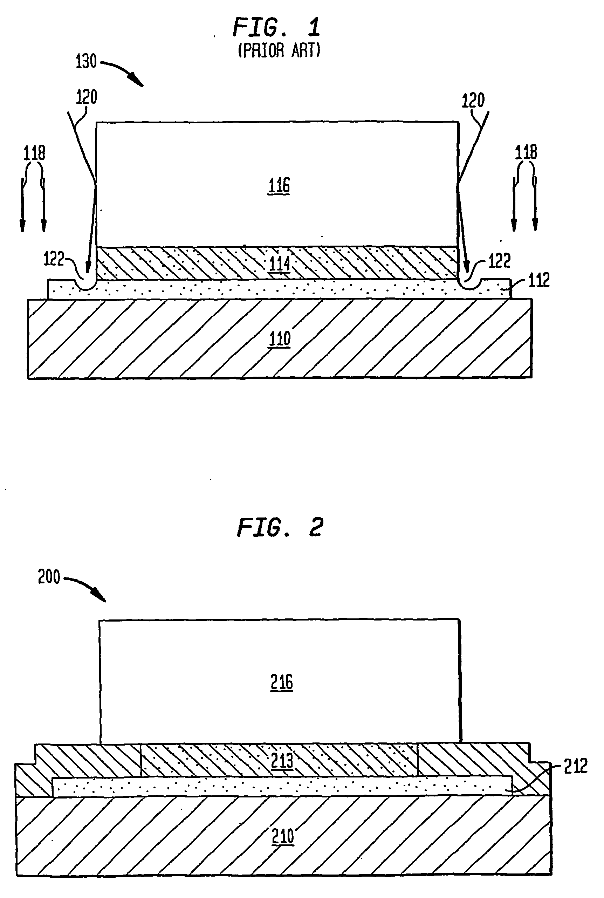

A MIM capacitor (MIMcap) is a particular type of capacitor having two metal plates sandwiched around a capacitor dielectric that is parallel to a semiconductor wafer surface. To form a MIMcap, the top metal plate must be lithographically patterned and then etched. Prior art methods of etching the top metal plate utilize reactive ion etching (RIE). The RIE process should stop upon contact with the capacitor dielectric with minimum erosion of the capacitor dielectric in order to have good reliability performance. Erosion of the capacitor dielectric during the top metal plate RIE has been shown to significantly deteriorate the reliability of a MIMcap. Figure 1 shows a cross-sectional view of a prior art MIMcap 130 having a top metal plate 114 formed by RIE. Capacitor dielectric 112 is disposed over bottom plate 110. A metal layer is deposited over the capacitor dielectric 112. A photoresist 116 is deposited over the metal layer, and is lithographically patterned with the desired shape of the top metal plate. The photoresist 116 is then exposed and developed remove exposed portions of the photoresist 116, leaving photoresist 116 portions over the metal layer.

The wafer is exposed to an anisotropic etchant 118 that comprises a gas having molecules that bombard the wafer in a substantially perpendicular direction, as shown. A typical type of anisotropic etch process used is plasma RIE, for example.

The shape and size of top metal plate 114 is very important in the design of a MIMcap 130. The top metal plate 114 determines various perimeters of the MIMcap 130, such as the capacitance value and leakage current, for example. An anisotropic etchant 118 process is used in the prior art because the dimensions of the top plate 114 need to be precisely patterned.

A problem with the MIMcap 130 top plate 114 fabrication process shown in Fig. 1 is that the anisotropic etchant gas 118 produces sidewall-scattered etchants 120 along the side of photoresist 116 and top metal plate 114. This results in the preferential etching of the capacitor dielectric 112 near the top plate 114 to form grooves 122, as shown. The over-etched grooves 122 significantly deteriorate the reliability of the MIMcap 130, because when exposed to high voltages in use, the MIMcap 100 may result in electrical breakdown near the grooves 122. Such electrical breakdown is caused by the thin region of capacitor dielectric 112 underlying grooves 122 suffering fatigue at higher voltages, for example.

Using a plasma RIE etch, it is difficult to control the erosion of the capacitor dielectric 122, especially the thinner the capacitor dielectric 122 is. If the capacitor dielectric 122 is very thin, having a thickness of around 500 Angstroms, for example, the fabrication of the top plate 114 can be particularly problematic. For the proper operation and reliability of the MIMcap 130, the erosion of the capacitor dielectric 122 needs to be controlled to less than 100 Angstroms, for example. It is desired that the remaining capacitor dielectric 122 after the top plate 114 etch process be around 400 Angstroms thick, for example. Frequently, after an anisotropic etch is used, the capacitor dielectric 122 thickness under grooves 122 is less than the desired 400 Angstroms thickness.

What is needed in the art is a MIMcap having a substantially uniform capacitor dielectric 112 and absent the over-etched grooves 122 found in the prior art. A method of forming a top plate of a MIMcap is needed that results in minimal erosion of the capacitor dielectric.

US5258093 discloses a process for fabricating a ferroelectric capacitor where the second electrode layer and ferroelectric layer are subjected to separate etching processes. Furukawa et al examines the effect of Barrel etching, Down- Stream etching and RIE etching on two-capacitor matching error results ("Process Dependence on Two-Capacitor Matching Properties with Different Etching Technique", IEEE Transactions on Electron Devices, IEEE Inc. New York, US, vol. 39, no.2, pages 453- 454). EP0932192/A1 discloses a means for etching a top platinum electrode by using an etchant gas containing at least one of chlorine, bromine and iodide followed by a heating process. Prior art documents EP0661730/A1, US5443688 and US5830792 disclose the etchant gases containing at least one of bromine, chlorine, fluorine and sulphur as a means for dry etching.

### SUNIMARY OF THE INVENTION

The present invention solves these problems of the prior art by providing a method of fabricating an MIM-capacito according to claim 1.

Disclosed is a method of fabricating a top plate of a metal-insulator-metal capacitor (MIMcap), the MIMcap comprising a bottom plate and a capacitor dielectric disposed over the bottom plate. The method comprises depositing a metal layer over the MIMcap dielectric, and exposing at least the metal layer to an isotropic etchant to form a top plate.

Also disclosed is a method of fabricating a metal-insulator-metal capacitor, comprising forming a bottom metal plate, depositing a capacitor dielectric over the bottom metal plate, depositing a metal layer over the capacitor dielectric, and exposing at least the metal layer to an isotropic etchant to form a top plate.

Further disclosed is a method of fabricating a metal-insulator-metal (MIM) capacitor, comprising forming a bottom conductive plate on a workpiece, depositing a capacitor dielectric over the bottom plate, and depositing a conductive layer over the capacitor dielectric. A photoresist is deposited over the conductive layer, and the photoresist is patterned and etched to leave patterned photoresist remaining over portions of the conductive layer. The conductive layer is exposed to an isotropic etchant to remove exposed portions of the conductive layer.

Advantages of the invention include providing an isotropic downstream plasma etch process for forming MIMcap top capacitor plates, without causing any damage to or over-etching the MIMcap dielectric. This results in a MIMcap having improved reliability compared with MIMcaps of the prior art. A more uniform etching profile of the MIMcap dielectric is provided. The fabrication method disclosed herein also results in a larger process window compared to using plasma RIE.

### BRIEF DESCRIPTION OF THE DRAWINGS

The above features of the present invention will be more clearly understood from consideration of the following descriptions in connection with accompanying drawings in which:
Figure 1 illustrates a cross-sectional diagram of a prior art MIMcap having a top plate formed by an anisotropic etch process; and
Figures 2-4 illustrate cross-sectional views of a MIMcap having a top plate formed by an isotropic etch process in accordance with the present invention in various stages of fabrication.

Corresponding numerals and symbols in the different figures refer to corresponding parts unless otherwise indicated. The figures are drawn to clearly illustrate the relevant aspects of the preferred embodiments, and are not necessarily drawn to scale.

### DETAILED DESCRIPTION OF PREFERRED EMBODIMENTS

Figures 2-4 illustrate cross-sectional views of a MIMcap 230 in accordance with the present invention at various stages of fabrication. A bottom plate 210 is formed on a substrate or a workpiece including component layers, for example (not shown), of a wafer 200. Bottom plate 210 preferably comprises a conductive material such as copper, aluminum, or tungsten, for example, and may alternatively comprise other conductive materials. The substrate or workpiece may include field oxide, active component regions, and/or shallow trench isolation or deep trench isolation regions, not shown.

A dielectric layer is deposited over the bottom plate 210. The dielectric layer preferably comprises silicon dioxide, and alternatively may comprise low or high dielectric constant materials, for example. The dielectric layer is patterned and etched to form capacitor dielectric 212 after the top conductive layer 214 is patterned and etched.

A conductive layer 213 is deposited over the capacitor dielectric 212. A photoresist is deposited over the conductive layer, and is patterned and etched to leave photoresist 216 over the conductive layer 213, as shown. The photoresist pattern 216 is designed to be a predetermined amount larger than the top capacitor plates to be formed. The photoresist 216 preferably comprises an organic polymer commonly used in semiconductor lithography, for example.

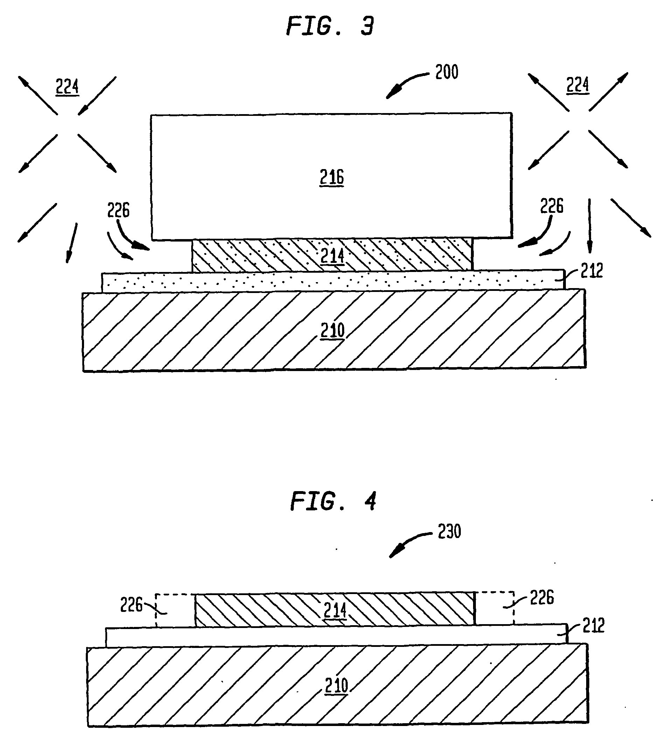

In accordance with the present invention, the wafer is exposed to an isotropic etchant 224, preferably comprising a gas, shown in Figure 3. Because the molecules in the isotropic etchant 224 move about randomly rather than directionally towards the surface of the wafer 200 as in prior art anisotropic etch processes, the isotropic gas 224 bombards the conductive layer 213 not only from the top surface, but also from the conductive layer 213 side surfaces, leaving top capacitor plate 214 having an undercut region 226 beneath the patterned photoresist 216, as shown. The isotropic etch process stops on the MIMcap capacitor dielectric 212 film.

The photoresist 216 is removed to leave the MIMcap 230 in accordance with the present invention, shown in Figure 4.

Because the etchant gas 224 used in the present invention is isotropic, rather than anisotropic as in the prior art, there is no preferential etching of the capacitor dielectric 212 underlying the top capacitor plate 214. This results in a MIMcap 230 having a uniform capacitor dielectric 212 thickness and improved reliability. The amount 226 of conductive material 213 removed may be determined and controlled by the type of gas used, time exposed, temperature, and pressure, for example.

The isotropic etchant 224 of the present invention comprises a mixture of CF₄, O₂, N₂, and CL₂, as shown in Table 1. Table 1 shows several experimental using a combination and a variety of these chemistries that resulted in successful MIMcap top plate 214 etching in an etch chamber.

**Table 1**

| Downstream Plasma Etching Condition | | | | | | | | | |
|---|---|---|---|---|---|---|---|---|---|
| *Experiment* | Temperature | Power | CF4 flow | 02 flow | N2 flow | C12 flow | Pressure | End point Time | Over etch Time |
| ***No.1*** | 130C | 700W | 150 sccm | 60sccm | 30sccm | 80sccm | 30Pa | 22sec | 15sec |
| ***No. 2*** | 130C | 700W | 150 sccm | 60sccm | 30sccm | 80sccm | 30Pa | 22sec | 30sec |
| ***No. 3*** | 130C | 700W | 150 sccm | 60sccm | 30sccm | 60sccm | 30Pa | 22sec | 15sec |
| ***No. 4*** | 130C | 700W | 150 sccm | 60sccm | 30sccm | 60sccm | 30Pa | 23sec | 30sec |
| ***No. 5*** | 130C | 700W | 150 sccm | 60sccm | 30sccm | 40sccm | 30Pa | 23sec | 15sec |
| ***No. 6*** | 130C | 700W | 150 sccm | 60sccm | 30sccm | 40sccm | 30Pa | 24sec | 30sec |

Alternatively, the isotropic etch gas 224 may also include argon and/or BCL₃, for example. More preferably, isotropic etchant gas 224 comprises 150 sccm of CF₄, 60 sccm of O₂, 30 sccm of N₂, and 40-80 sccm of CL₂, as shown in Table 1. Furthermore, the wafer 200 is preferably exposed to the isotropic etchant gas 224 at a temperature of 130°C at a pressure of 30 Pa, for a duration of an etching time of 37-54 seconds, with an endpoint time of 22-24 seconds, and an over-etch time of 15-30 seconds, for example.

The amount of conductive material 213 etched in the undercut region 226 may be precisely determined and controlled by patterning the photoresist 216 to be larger than the top plate 214 by a predetermined amount equal to the desired size of the undercut region 226. The amount of conductive material 213 etched in the undercut region 226 may also be controlled by the selection of the etchant 224 chemistries and processing parameters, to produce a top capacitive plate 214 having the desired dimensions, for example.

Prior art anisotropic etch processes used to form a top capacitor plate 114 of a MIMcap 130 shown in Figure 1 typically comprise an RIE, during which a plasma source in a high-power environment generates plasma directly in the presence of the wafer, which is a very active and volatile environment for the semiconductor wafer 100. In contrast, the isotropic etchant gas 224 used to form the top capacitor plate 214 in accordance with the present invention is preferably generated downstream; that is, the plasma for the isotropic etchant gas 224 is generated at a source positioned away from the wafer 200 by a distance, for example, one meter. In this manner, an isotropic etchant gas 224 is produced that effects the wafer 200 surface uniformly rather than being directionally aimed at the wafer 200 causing non-uniform etching of the capacitor dielectric 112 as in the prior art.

The present invention achieves technical advantages as an isotropic downstream plasma etch process for forming MIMcap top capacitor plates 214, without causing any damage to or over-etching the MIMcap dielectric 212. This results in a MIMcap 230 having improved reliability compared with MIMcaps 130 of the prior art. A more uniform etching profile of the MIMcap dielectric 212 is provided. The fabrication method disclosed herein results in a larger process window compared to using plasma RIE.

While the invention has been described with reference to illustrative embodiments, this description is not intended to be construed in a limiting sense. Various modifications in combinations of the illustrative embodiments, as well as other embodiments of the invention, will be apparent to persons skilled in the art upon reference to the description. For example, while a cross-sectional view of the present MIMcap 230 is shown, the MIMcap 230 plates 210 and 214 are preferably square or rectangular, and may run lengthwise along the semiconductor wafer 200 by a distance (not shown) according to the capacitance desired.

## Claims

1. A method of fabricating a metal-insulator-metal (MIM)capacitor (230), comprising:
- forming a bottom conductive plate (210) on a workpiece;
- depositing a capacitor dielectric (212) over the bottom plate;
- depositing a conductive layer (213) over the capacitor dielectric (212);
- depositing a photoresist (216) over the conductive layer (213);
- patterning and etching the photoresist (216) to leave patterned photoresist remaining over portions of the conductive layer (213), wherein the photoresist pattern is designed to be a predetermined amount larger than the desired area of the conductive layer (214); and
- exposing the conductive layer (213) to an isotropic etchant gas (224), comprising CF₄, O₂, N₂, and Cl₂ to remove exposed portions of the conductive layer (226), thereby undercutting a portion of the conductive layer from beneath the photoresist (216); and
- removing the photoresist (216).

2. The method according to Claim 1 wherein exposing at least the conductive layer (213) to an isotropic etchant (224) includes exposing the capacitor dielectric (212) to the isotropic etchant (224).

3. The method according to Claim 1 wherein exposing at least the conductive layer (213) to an isotropic etchant (224) comprises exposing the conductive layer (213) to an etchant gas which also comprises argon.

4. The method according to Claim 1 wherein exposing at least the conductive layer (213) to an isotropic etchant (224) comprises exposing the conductive layer (213) to an etchant gas which also comprises BCl₃.

5. The method according to Claim 1 wherein depositing a layer (213) comprises depositing a metal, wherein the capacitor dielectric (212) comprises silicon dioxide.

6. The method according to Claim 1 wherein exposing the conductive layer (213) to an isotropic etchant (224) comprises exposing the conductive layer (213) to a downstream plasma etch process.

## Patentansprüche

1. Ein Verfahren zum Herstellen eines Metall-Isolator-Metall- (MIM)- Kondensators (230), aufweisend:
- Bilden einer unteren leitfähigen Platte (210) auf einem Werkstück,
- Abscheiden eines Kondensator-Dielektrikums (212) über der unteren Platte,
- Abscheiden einer leitfähigen Schicht (213) über dem Kondensator-Dielektrikum (212),
- Abscheiden eines Fotoresistlacks (216) über der leitfähigen Schicht (213),
- Strukturieren und Ätzen des Fotoresistlacks (216), um einen strukturierten Fotoresistlack über Abschnitten der leitfähigen Schicht (213) übrigzulassen, wobei die Fotoresistlack-Struktur bestimmt ist, um in einer vorbestimmten Menge zu sein, die größer als die gewünschte Fläche der leitfähigen Schicht (214) ist, und
- Aussetzen der leitfähigen Schicht (213) einem isotropen Ätzmittelgas (224), das CF₄, O₂, N₂ und Cl₂ aufweist, um freigelegte Abschnitte der leitfähigen Schicht (226) zu entfernen, wodurch ein Abschnitt der leitfähigen Schicht von unterhalb des Fotoresistlacks (216) aus hinterschnitten wird, und
- Entfernen des Fotoresistlacks (216).

2. Das Verfahren gemäß Anspruch 1, wobei das Aussetzen von zumindest der leitfähigen Schicht (213) einem isotropen Ätzmittel (224) das Aussetzen des Kondensator-Dielektrikums (212) dem isotropen Ätzmittel (224) beinhaltet.

3. Das Verfahren gemäß Anspruch 1, wobei das Aussetzen zumindest der leitfähigen Schicht (213) einem isotropen Ätzmittel (224) das Aussetzen der leitfähigen Schicht (213) einem Ätzmittelgas beinhaltet, welches auch Argon aufweist.

4. Das Verfahren gemäß Anspruch 1, wobei das Aussetzen von zumindest der leitfähigen Schicht (213) einem isotropen Ätzmittel (224) das Aussetzen der leitfähigen Schicht (213) einem Ätzmittelgas beinhaltet, welches auch BCl₃ aufweist.

5. Das Verfahren gemäß Anspruch 1, wobei das Abscheiden einer Schicht (213) das Abscheiden eines Metalls aufweist, wobei das Kondensator-Dielektrikum (212) Siliziumdioxid aufweist.

6. Das Verfahren gemäß Anspruch 1, wobei das Aussetzen der leitfähigen Schicht (213) einem isotropen Ätzmittel (224) das Aussetzen der leitfähigen Schicht (213) einem Stromabwärts-Plasma-Ätzvorgang aufweist.

## Revendications

1. Procédé de fabrication d'un condensateur (230) métal-isolant-métal (MIM) comprenant :
- la formation d'une plaque (210) conductrice de fond sur une pièce :
- le dépôt d'un diélectrique (212) de condensateur sur la plaque de fond ;
- le dépôt d'une couche (213) conductrice sur le diélectrique (212) de condensateur ;
- le dépôt d'une réserve (216) photosensible sur la couche (213) conductrice :
- la structuration et l'attaque de la réserve (216) photosensible pour laisser une réserve photosensible structurée restant sur des parties de la couche (213) conductrice, la structure de la réserve photosensible étant conçue pour être plus grande d'une quantité déterminée à l'avance que la superficie souhaitée de la couche (214) conductrice : et
- l'exposition de la couche (213) conductrice à un gaz (224) isotrope d'attaque comprenant CF₄, O₂, N₂ et Cl₂ pour éliminer des parties exposées de la couche (226) conductrice, en attaquant ainsi une partie de la couche conductrice par-dessous la réserve (216) photosensible ; et
- l'élimination de la réserve (216) photosensible.

2. Procédé suivant la revendication 1, dans lequel exposer au moins la couche (213) conductrice à un agent (224) isotrope d'attaque comprend exposer le diélectrique (212) de condensateur à l'agent (224) isotrope d'attaque.

3. Procédé suivant la revendication 1, dans lequel exposer au moins la couche (213) conductrice à un agent (224) isotrope d'attaque comprend exposer la couche (213) conductrice à un gaz d'attaque qui comprend aussi de l'argon.

4. Procédé suivant la revendication 1, dans lequel exposer au moins la couche (213) conductrice à un agent (224) isotrope d'attaque comprend exposer la couche (213) conductrice à un gaz d'attaque qui comprend aussi du BCl₃.

5. Procédé suivant la revendication 1, dans lequel déposer une couche (213) comprend déposer un métal, le diélectrique (212) de condensateur comprenant du dioxyde de silicium.

6. Procédé suivant la revendication 1, dans lequel exposer la couche (213) conductrice à un agent (224) isotrope d'attaque comprend exposer la couche (213) conductrice à un procédé d'attaque par plasma en aval.
